# EUROPÄISCHE PATENTSCHRIFT

(11) **EP 2 595 259 B1**
(45) Veröffentlichungstag und Bekanntmachung des Hinweises auf die Patenterteilung: **01.01.2020**
(21) Anmeldenummer: 12191454.3
(22) Anmeldetag: 06.11.2012
(51) Int. Cl.: H01S 5/12, H01L 33/00, H01L 33/10, H01S 5/323

(54) **Diodenlaser und Verfahren zur Herstellung eines Diodenlasers mit hoher Effizienz**
Diode laser and method for producing a diode laser with high efficiency
Diode laser et procédé de fabrication d'une diode laser à haut rendement

(30) Priorität: 21.11.2011 DE 102011086744
(43) Veröffentlichungstag der Anmeldung: 22.05.2013
(73) Patentinhaber: Forschungsverbund Berlin e.V., 12489 Berlin (DE)
(72) Erfinder: Brox, Olaf, 14057 Berlin (DE); Bugge, Frank, 12555 Berlin (DE); Crump, Paul, 10245 Berlin (DE); Erbert, Götz, 02708 Löbau (DE); Maaßdorf, Andre, 10247 Berlin (DE); Schultz, Christoph M., 12555 Berlin (DE); Wenzel, Hans, 12355 Berlin (DE); Weyers, Markus, 15745 Wildau (DE)
(74) Vertreter: Gulde & Partner

(56) Entgegenhaltungen:
- US-A1- 2002 127 755
- US-A1- 2005 208 768
- US-B1- 6 459 715

## Beschreibung

Die vorliegende Erfindung betrifft einen Diodenlaser mit hoher Effizienz und ein Verfahren zu dessen Herstellung.

### Stand der Technik

GaAs-basierte Breitstreifenlaserdioden erreichen hohe Leistungen > 5 W mit gutem Wirkungsgrad > 60 %, weisen jedoch eine spektrale Breite ≥ 2 nm mit relativ starker Temperaturempfindlichkeit > 0,3 nm/K auf. Anwendungen wie das Pumpen von Festkörperlasern mit schmalen Absorptionsbanden erfordern jedoch eine höhere Stabilität der Emissionswellenlänge.

Eine Stabilisierung der Emissionswellenlänge kann erzielt werden, indem ein Braggsches Gitter (nachfolgend auch als Bragg-Gitter bezeichnet) in den Laser integriert wird. Dadurch kann eine spektrale Breite < 1 nm mit verbesserter Temperaturempfindlichkeit < 0,1 nm/K erreicht werden.

Die Verwendung von Braggschen Gittern in Diodenlasern ist beispielsweise aus DE 10 2009 028 823 A1, US 6,459,715 B1 und US 6,560,259 B1 bekannt.

Aus US 2002/0127755 A1 ist bekannt, dass die Verwendung von aluminiumhaltigen Materialien (z.B. AIGaAs als halbleitendes aluminiumhaltiges Material) für Laserdesigns mit Emissionswellenlänge im Bereich von 600 nm bis 1600 nm vorteilhaft ist. Das epitaktische Überwachsen solcher Materialien ist jedoch problematisch. Durch die Präparation eines Bragg-Gitters außerhalb des Epitaxie-Reaktors (z.B. an Luft), wird die freiliegende (aluminiumhaltige) Halbleiteroberfläche oxidiert. Anders als beispielsweise Galliumoxid, lässt sich Aluminiumoxid anschließend nicht mehr thermisch desorbieren oder anderweitig effizient entfernen. Dies führt zu einem defektreichen Kristallwachstum der Folgeschichten. Gleichzeitig ist die Defektpropagationsrate in aluminiumhaltigen Schichten besonders hoch, so dass eingebaute Defekte sehr weitreichend sein können.

Die Implementierung eines Bragg-Gitters zur Stabilisierung der Emissionswellenlänge in konventionellen Laserdioden mit aluminiumhaltigen Schichten geht nachteilhaft mit einer starken Reduzierung der Leistung bzw. mit einem stark reduzierten Wirkungsgrad einher.

Aus US 2005/0208768 A1 ist ein zweistufiger Herstellungsprozess bekannt, bei dem zunächst in einem ersten Reaktor durch einen Ätzprozess eine Gittermaske in einer Schicht aus einem Halbleitermaterial erzeugt wird und anschließend in einem zweiten Reaktor das Gitter in eine darunter befindliche Schutzschicht übertragen wird. Die Schutzschicht schützt dabei eine unmittelbar unterhalb der Schutzschicht angeordnete oxidationsempfindliche Halbleiteroberfläche. Dabei sollte jedoch ein störender Einfluss der Schutzschicht möglichst gering gehalten werden.

### Offenbarung der Erfindung

Es ist daher Aufgabe der vorliegenden Erfindung, einen Diodenlaser mit aluminiumhaltigen Schichten und einem zur Stabilisierung der Emissionswellenlänge implementierten Bragg-Gitter zu beschreiben, der im Vergleich zu herkömmlichen Laserdioden mit einem monolithisch integrierten Bragg-Gitter eine höhere Leistung und/oder einen höheren Wirkungsgrad aufweist. Eine weitere Aufgabe der vorliegenden Erfindung besteht darin, ein Verfahren zur Implementierung eines Bragg-Gitters in eine aluminiumhaltige Schicht anzugeben, das im Vergleich zu herkömmlichen Verfahren nur zu einem sehr geringfügigen Einbau von Sauerstoffatomen in den Halbleiterkristall der aluminiumhaltigen Schicht führt.

Diese Aufgaben werden erfindungsgemäß durch die Merkmale des Patentanspruchs 1 gelöst. Zweckmäßige Ausgestaltungen der Erfindung sind in den Unteransprüchen enthalten.

Die Idee der vorliegenden Erfindung besteht darin, dass zur Einbringung des Bragg-Gitters eine Aufteilung des Wachstumsprozesses in zwei Teilschritte vorgesehen wird, wobei eine kontinuierliche aluminiumfreie Schicht und eine aluminiumfreie Maskenschicht in einem ersten Wachstumsprozess derart aufgebracht werden, dass die aluminiumhaltige Schicht vollständig von der kontinuierlichen aluminiumfreien Schicht überdeckt wird. Daher kann eine Strukturierung der Maskenschicht außerhalb eines Reaktors erfolgen, ohne dass es zu einer ungewollten Oxidation der aluminiumhaltigen Schicht kommt.

Durch Ätzung innerhalb eines Reaktors wird die Strukturierung der Maskenschicht derart in die aluminiumfreie Schicht oder in die aluminiumfreie Schicht und in die darunter liegende aluminiumhaltige Schicht abgeformt, dass ein Bragg-Gitter entsteht. Darauf wird eine zweite bevorzugt aluminiumhaltige Schicht innerhalb des Reaktors epitaktisch aufgewachsen.

Das erfindungsgemäße Verfahren zur Herstellung eines Diodenlasers weist folgende Verfahrensschritte auf: Ausbilden einer ersten Mantelschicht, einer ersten Wellenleiterschicht, einer aktiven Schicht, einer zweiten Wellenleiterschicht, und einer zweiten Mantelschicht, wobei mindestens eine Schicht ausgewählt aus der Gruppe erste Mantelschicht, erste Wellenleiterschicht, zweite Wellenleiterschicht und zweite Mantelschicht eine erste aluminiumhaltige Schicht aufweist; und Ausbilden eines Bragg-Gitters auf oder innerhalb der ersten aluminiumhaltigen Schicht, wobei die Ausbildung des Bragg-Gitters folgende Schritte umfasst:
a) auf die erste aluminiumhaltige Schicht werden innerhalb eines Reaktors eine kontinuierliche aluminiumfreie Schicht und nachfolgend auf die aluminiumfreie Schicht eine kontinuierliche aluminiumfreie Maskenschicht derart aufgebracht, so dass die erste aluminiumhaltige Schicht vollständig von der kontinuierlichen aluminiumfreien Schicht überdeckt wird,
b) nachfolgend wird eine Lackmaske (außerhalb des Reaktors) auf die kontinuierliche Maskenschicht aufgebracht und strukturiert, und nachfolgend wird die kontinuierliche Maskenschicht durch Ätzung (außerhalb des Reaktors) derart strukturiert, dass die Maskenschicht der Struktur der Lackmaske entspricht oder im Wesentlichen entspricht, die aluminiumfreie Schicht zumindest teilweise freiliegt und die aluminiumhaltige Schicht von der aluminiumfreien Schicht vollständig überdeckt wird,
c) nachfolgend wird die aluminiumfreie Schicht innerhalb eines Reaktors unter Verwendung der strukturierten Maskenschicht als Ätzmaske derart geätzt, dass die aluminiumfreie Schicht eine Gitterstruktur aufweist, ohne dass die erste aluminiumhaltige Schicht freigelegt wird (erste, bevorzugte Ausführungsvariante), oder die erste aluminiumhaltige Schicht wird zwischen den Gitterstegen der aluminiumfreien Schicht freigelegt (zweite, besonders bevorzugte Ausführungsvariante), oder es wird geätzt, bis die Gitterstruktur in die erste aluminiumhaltige Schicht selbst abgeformt ist (dritte, bevorzugte Ausführungsvariante),
d) nachfolgend wird innerhalb eines Reaktors eine zweite (vorzugsweise) aluminiumhaltige Schicht aufgebracht, dadurch gekennzeichnet, dass
die aluminiumfreie Schicht vor Durchführung des Verfahrenschrittes d) derart strukturiert wird, dass die aluminiumhaltige Schicht von der aluminiumfreien Schicht nicht freigelegt wird, oder dass die aluminiumfreie Schicht vor Durchführung des Verfahrenschrittes d) vollständig weggeätzt wird.

Vorzugsweise wird die kontinuierliche aluminiumhaltige Schicht in Schritt a) innerhalb eines Reaktors aufgewachsen.

Vorzugsweise wird Verfahrensschritt b) außerhalb des in Verfahrensschritt a) verwendeten Reaktors durchgeführt.

Vorzugsweise wird für die Verfahrensschritte a), c) und d) derselbe Reaktor verwendet.

Vorzugsweise ist der Sauerstoffpartialdruck innerhalb des Reaktors während der Verfahrensschritte a), c) und d) kleiner als 5^{∗}10⁻⁶ Pa, bevorzugter kleiner als 1^{∗}10⁻⁷ Pa.

Vorzugsweise ist der Sauerstoffpartialdruck während der Durchführung des Verfahrensschrittes b) (vorzugsweise an Raumluft, 20°C) größer als 5^{∗}10⁻⁶ Pa, bevorzugter größer als 5^{∗}10⁻⁵ Pa.

Vorzugsweise wird die Lackmaske derart strukturiert, dass sie der Struktur des auszubildenden Bragg-Gitters entspricht oder im Wesentlichen entspricht.

Vorzugsweise wird die aluminiumfreie Schicht vor Durchführung des Verfahrenschrittes d) im Reaktor unter Einsatz eines ätzenden gasförmigen Mediums (z.B. CBr₄, CCl₄ o.ä.) derart strukturiert, dass Teilbereiche der aluminiumhaltigen Schicht von der aluminiumfreien Schicht freigelegt werden.

Vorzugsweise wird die aluminiumfreie Schicht vor Durchführung des Verfahrenschrittes d) derart strukturiert, dass Teilbereiche der aluminiumhaltigen Schicht von der aluminiumfreien Schicht freigelegt werden.

Vorzugsweise wird die Maskenschicht vor Durchführung des Verfahrenschrittes d) im Reaktor unter Einsatz eines ätzenden gasförmigen Mediums vollständig weggeätzt.

Vorzugsweise wird die aluminiumfreie Schicht vor Durchführung des Verfahrenschrittes d) in den freigelegten Bereichen vollständig weggeätzt.

Vorzugsweise wird die aluminiumfreie Schicht vor Durchführung des Verfahrenschrittes d) vollständig weggeätzt (für die dritte, bevorzugte Ausführungsvariante).

Die aluminiumfreie Maskenschicht und die aluminiumfreie Schicht können auch aus mehreren, jeweils aluminiumfreien Teilschichten bestehen oder eine gemeinsame Schicht bilden, was unter bestimmten Umständen vorteilhaft für die technologische Herstellung der Gitterstruktur sein kann, z.B. durch die Anwendbarkeit von selektiven Ätzprozessen.

Vorzugsweise wird als aluminiumfreie Maskenschicht Galliumarsenid oder Galliumarsenidphosphid verwendet. Vorzugsweise wird als aluminiumfreie Schicht ein Verbindungshalbleiter-Material, welches aus den Elementen Indium, Gallium, Phosphor, Arsen, Antimon und Stickstoff bestehen kann, verwendet, also zum Beispiel Galliumarsenid, Galliumindiumphosphid oder Galliumarsenidphosphid.

Vorzugsweise wird für die Verfahrensschritte a), c) und d) derselbe Reaktor verwendet.

Der erfindungsgemäße Diodenlaser umfasst: eine erste (vorzugsweise n-leitend ausgebildete) Mantelschicht, eine erste (vorzugsweise n-leitend ausgebildete) Wellenleiterschicht, die auf der ersten Mantelschicht angeordnet ist, eine aktive Schicht, die zur Strahlungserzeugung geeignet ist und die auf der ersten Wellenleiterschicht angeordnet ist, eine zweite (vorzugsweise p-leitend ausgebildete) Wellenleiterschicht, die auf der aktiven Schicht angeordnet ist, und eine zweite (vorzugsweise p-leitend ausgebildete) Mantelschicht, die auf der zweiten Wellenleiterschicht angeordnet ist, und ein Bragg-Gitter, wobei mindestens eine Schicht ausgewählt aus der Gruppe erste Mantelschicht, erste Wellenleiterschicht, zweite Wellenleiterschicht und zweite Mantelschicht aluminiumhaltig ist; und wobei das Bragg-Gitter auf oder innerhalb der mindestens einen aluminiumhaltigen Schicht ausgebildet ist, wobei die Grenzfläche zwischen dem Bragg-Gitter und der mindestens einen aluminiumhaltigen Schicht eine Konzentration von Sauerstoff kleiner als 1 % (< 10¹⁹ cm⁻³), bevorzugter kleiner als 0,1 % (< 10¹⁸ cm⁻³) und noch bevorzugter kleiner als 0,01 % (< 10¹⁷ cm⁻³) aufweist. Die Grenzfläche hat vorzugsweise eine Dicke von bis zu 50 nm.

Es ist bevorzugt, dass sich der Aluminiumgehalt der ersten aluminiumhaltigen Schicht vom Aluminiumgehalt der in Verfahrenschritt d) aufgebrachten, zweiten aluminiumhaltigen Schicht unterscheidet. In einer alternativen, bevorzugten Ausführungsvariante, ähnelt oder entspricht der Aluminiumgehalt der ersten aluminiumhaltigen Schicht dem Aluminiumgehalt der in Verfahrenschritt d) aufgebrachten, zweiten aluminiumhaltigen Schicht.

Als aluminiumfreie Schicht im Sinne der vorliegenden Erfindung wird vorzugsweise eine Schicht mit einem Aluminiumgehalt von weniger als 3 % (bezogen auf das Volumen), bevorzugter weniger als 1 % und noch bevorzugter weniger als 0,1 % verstanden. Als aluminiumhaltige Schicht im Sinne der vorliegenden Erfindung wird vorzugsweise eine Schicht mit einen Aluminiumgehalt von mehr als 3 % (bezogen auf das Volumen), bevorzugter mehr als 5 % und noch bevorzugter mehr als 10 % verstanden.

Die Idee der vorliegenden Erfindung besteht gemäß einem zweiten Aspekt darin, dass eine aluminiumhaltige Schicht unter Aufteilung des Wachstumsprozesses in zwei Teilschritte zu strukturieren, wobei eine kontinuierliche aluminiumfreie Schicht und eine aluminiumfreie Maskenschicht nach dem ersten Wachstumsprozess kontinuierlich (auf eine unstrukturierte aluminiumhaltige Schicht) derart aufgebracht werden, dass die aluminiumhaltige Schicht vollständig von der kontinuierlichen aluminiumfreien Schicht überdeckt wird. Daher kann die Strukturierung (der Maskenschicht) außerhalb eines Reaktors erfolgen, ohne dass es zu einer ungewollten Oxidation der (ansonsten) freiliegenden aluminiumhaltigen Halbleiteroberfläche kommt. Die weitere Strukturierung der kontinuierlichen aluminiumfreien Schicht und damit der aluminiumhaltigen Schicht erfolgt dann wieder innerhalb eines Reaktors bei ausreichend niedrigem Sauerstoffpartialdruck.

Das erfindungsgemäße Verfahren zur Herstellung einer strukturierten aluminiumhaltigen Schicht weist folgende Verfahrensschritte auf:
e) Bereitstellen einer kontinuierlichen aluminiumhaltigen Schicht,
f) auf die kontinuierliche aluminiumhaltige Schicht wird innerhalb eines Reaktors eine kontinuierliche aluminiumfreie Schicht aufgebracht, und nachfolgend auf die aluminiumfreie Schicht eine kontinuierliche aluminiumfreie Maskenschicht derart aufgebracht, dass die aluminiumhaltige Schicht vollständig von der kontinuierlichen aluminiumfreien Schicht überdeckt wird,
g) nachfolgend wird eine Lackmaske auf die kontinuierliche Maskenschicht aufgebracht und strukturiert, und nachfolgend wird die kontinuierliche Maskenschicht durch Ätzung derart strukturiert, dass die Maskenschicht der Struktur der Lackmaske entspricht oder im Wesentlichen entspricht, die aluminiumfreie Schicht zumindest teilweise freiliegt und die aluminiumhaltige Schicht von der aluminiumfreien Schicht vollständig überdeckt wird,
h) nachfolgend wird die aluminiumfreie Schicht innerhalb eines Reaktors durch Ätzung der strukturierten Maskenschicht derart strukturiert, dass die aluminiumfreie Schicht eine Gitterstruktur aufweist, und
i) nachfolgend wird innerhalb eines Reaktors eine zweite vorzugsweise aluminiumhaltige Schicht aufgebracht.

Vorzugsweise wird die kontinuierlich aluminiumhaltige Schicht in Schritt e) innerhalb eines Reaktors aufgewachsen.

Vorzugsweise wird Verfahrensschritt g) außerhalb des in Verfahrensschritt f) verwendeten Reaktors durchgeführt. Vorzugsweise ist der Sauerstoffpartialdruck innerhalb des Reaktors während der Verfahrensschritte e), f), h) und i) kleiner als 5^{∗}10⁻⁶ Pa, bevorzugter kleiner als 1^{∗}10⁻⁷ Pa. Vorzugsweise ist der Sauerstoffpartialdruck während der Durchführung des Verfahrensschrittes g) größer als 5^{∗}10⁻⁶ Pa, bevorzugter größer als 5^{∗}10⁻⁵ Pa.

Vorzugsweise wird die aluminiumfreie Schicht vor Durchführung des Verfahrenschrittes i) derart strukturiert, dass Teilbereiche der aluminiumhaltigen Schicht von der aluminiumfreien Schicht freigelegt werden.

Vorzugsweise wird die Maskenschicht vor Durchführung des Verfahrenschrittes i) vollständig weggeätzt. Vorzugsweise wird die aluminiumfreie Schicht vor Durchführung des Verfahrenschrittes i) vollständig weggeätzt.

Die aluminiumfreie Maskenschicht und die aluminiumfreie Schicht können auch aus mehreren, jeweils aluminiumfreien Teilschichten bestehen oder eine gemeinsame Schicht bilden, was unter bestimmten Umständen vorteilhaft für die technologische Herstellung der Gitterstruktur sein kann, z.B. durch die Anwendbarkeit von selektiven Ätzprozessen.

Vorzugsweise wird als aluminiumfreie Schicht ein Verbindungshalbleiter-Material, welches aus den Elementen Indium, Gallium, Phosphor, Arsen, Antimon und Stickstoff bestehen kann, verwendet, also zum Beispiel Galliumarsenid, Galliumindiumphosphid oder Galliumarsenidphosphid. Vorzugsweise wird für die Verfahrensschritte e), f), h) und i) derselbe Reaktor verwendet.

### Kurzbeschreibung der Zeichnungen

Die Erfindung wird nachfolgend anhand von Ausführungsbeispielen näher erläutert. Es zeigen:
- Fig. 1: eine erfindungsgemäße Laserdiode gemäß einem ersten Ausführungsbeispiel in schematischer perspektivischer Darstellung,
- Fig. 2: eine erfindungsgemäße Laserdiode gemäß einem zweiten Ausführungsbeispiel in schematischer perspektivischer Darstellung,
- Fig. 3: die einzelnen Schritte zur erfindungsgemäßen Herstellung eines Bragg-Gitters in der erfindungsgemäßen Laserdiode gemäß einer ersten, zweiten und dritten bevorzugten Ausführungsvariante, und
- Fig. 4: den Zusammenhang zwischen der Ätzzeit und dem Sauerstoffgehalt in der Grenzschicht zwischen dem Bragg-Gitter und der (mindestens einen aluminiumhaltigen) Wellenleiterschicht.

### Ausführliche Beschreibung der Zeichnungen

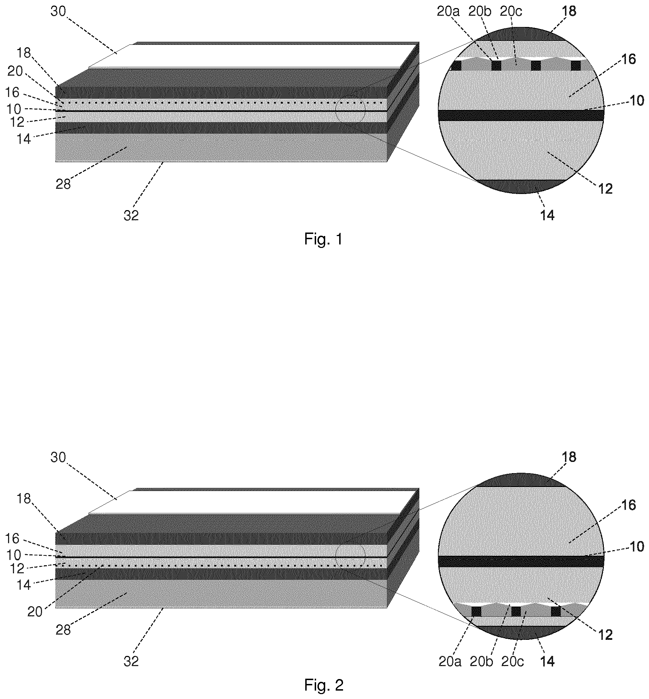

Fig. 1 und 2 zeigen beispielhaft je eine erfindungsgemäße Laserdiode in schematischer perspektivischer Darstellung.

Die erfindungsgemäße Laserdiode weist einen vertikalen Schichtaufbau mit einem Substrat 28, einer darauf angeordneten, ersten n-leitenden Mantelschicht 14, einer darauf angeordneten, ersten n-leitenden Wellenleiterschicht 12, einer darauf angeordneten aktiven Schicht 10, einer darauf angeordneten, zweiten p-leitenden Wellenleiterschicht 16 und einer darauf angeordneten, zweiten p-leitenden Mantelschicht 18 auf.

Weiterhin weist die Laserdiode vorzugsweise Kontakte 30 und 32 zur Injektion von Ladungsträgern auf. Durch die so gebildete Struktur können Ladungsträger einer ersten Polarität jeweils über den ersten Kontakt 32, die erste Mantelschicht 14 (hier vorzugsweise n-leitend) und die erste Wellenleiterschicht 12 (hier vorzugsweise n-leitend) in die aktive Schicht 10 und Ladungsträger der entgegengesetzten Polarität jeweils über den zweiten Kontakt 30, die zweite Mantelschicht 18 (hier vorzugsweise p-leitend) und die zweite Wellenleiterschicht 16 (hier vorzugsweise p-leitend) ebenfalls in die aktive Schicht 10 gelangen und dort rekombinieren, wodurch eine Emission von Licht hervorgerufen wird.

Zur Stabilisierung der Emissionswellenlänge wird ein Braggsches Gitter 20 mittels eines zweistufigen Epitaxieprozesses in den Laser integriert. Das Braggsche Gitter 20 kann innerhalb der p-leitenden (zweiten) Wellenleiterschicht 16 (Fig. 1) oder innerhalb der n-leitenden (ersten) Wellenleiterschicht 12 (Fig. 2) integriert sein. Die Position des Braggschen Gitters 20 ist jedoch nicht auf die Ausführungsbeispiele der Figuren 1 und 2 beschränkt. Vielmehr ist es alternativ auch möglich, das Braggsche Gitter 20 innerhalb einer der Mantelschichten zu integrieren oder an einer der Grenzflächen zwischen Mantelschicht und Wellenleiterschicht anzuordnen. Es wäre sogar denkbar, das Braggsche Gitter 20 im äußeren (zu den Kontakten zeigenden) Randbereich der Mantelschichten anzuordnen.

Weiterhin weist die Laserdiode vorzugsweise an den seitlichen, gegenüberliegenden Enden (hier nicht dargestellte) passivierte Facetten mit Reflektivitäten auf, welche durch die Beschichtung mit dünnen dielektrischen Schichten individuell eingestellt und an die jeweilige Funktionsweise des Lasers angepasst werden können. Die für den Laserbetrieb erforderliche Rückkopplung des sich entlang des Wellenleiters ausbreitenden Lichts kommt durch die Wirkung des Gitters und der Facetten zustande.

Da die Verwendung von aluminiumhaltigen Materialien (z.B. AIGaAs als halbleitendes aluminiumhaltiges Material für die Wellenleiterschicht) für Laserdesigns mit Emissionswellenlänge im Bereich von 600 nm bis 1600 nm vorteilhaft ist, ist es wünschenswert, das Braggsche Gitter 20 innerhalb oder auf einer aluminiumhaltigen Schicht (Wellenleiterschicht oder Mantelschicht) auszubilden, jedoch ohne die aluminiumhaltige Halbleiteroberfläche zu oxidieren, da dies mit einer Reduzierung der Leistung aufgrund eines defektreichen Kristallwachstums der Folgeschichten einherginge. Natürlich kann das Braggsche Gitter 20 auch zwischen zwei Schichten angeordnet sein, wobei mindestens eine der Schichten eine aluminiumhaltige Schicht ist.

Wie in Fig. 1 und 2 dargestellt, weist das Braggsche Gitter 20, das jeweils in einer der Wellenleiterschichten (12 bzw. 16) integriert ist, in einer bevorzugten Ausführungsvariante einen Gittersteg 20a (aus einem aluminiumfreien Material), eine Region 20b mit erhöhtem Aluminiumgehalt im Bereich der Gitterstege 20a und eine Region 20c mit reduziertem Aluminiumgehalt im Bereich zwischen den Gitterstegen 20a auf.

Aufgrund der erfindungsgemäßen Aufteilung des Wachstumsprozesses der aluminiumhaltigen Schicht des Braggschen Gitters 20 in zwei Teilschritte ist es möglich, eine Oxidierung der Grenzfläche zwischen dem Bragg-Gitter (das auch eine aluminiumhaltige Schicht umfassen kann) und der mindestens einen aluminiumhaltigen Schicht (der Laserdiode, wie zum Beispiel einer Wellenleiterschicht) zu vermeiden, so dass die Konzentration von Sauerstoff im Bereich der Grenzfläche bevorzugt kleiner als 10¹⁷cm⁻³ ist. Dies führt trotz einer (aufgrund des Bragg-Gitters erreichten) Stabilisierung der Emissionswellenlänge zu keiner Reduzierung der Leistung bzw. des Wirkungsgrades.

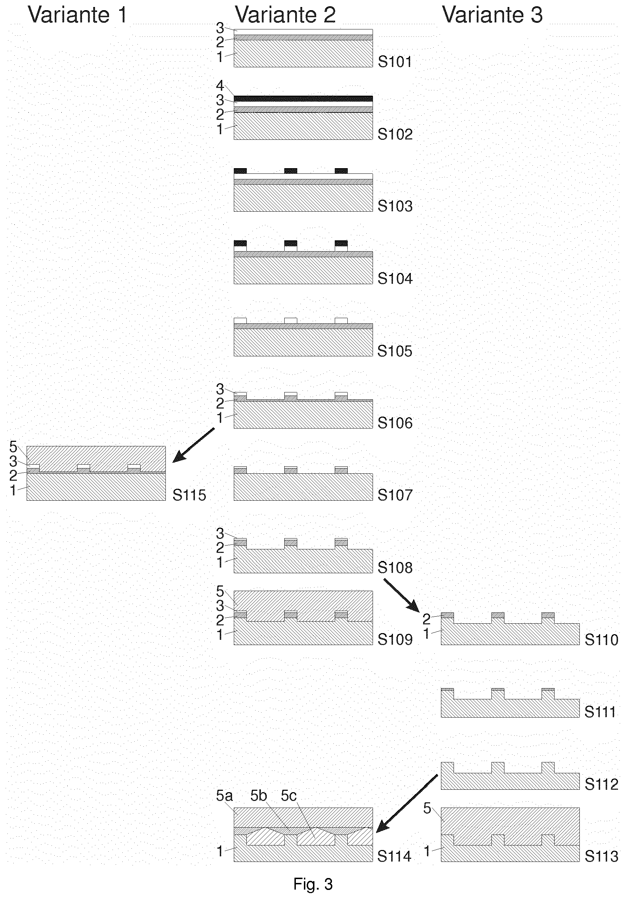

Fig. 3 zeigt die einzelnen Verfahrensschritte einer Vielzahl bevorzugter Ausführungsbeispiele zur erfindungsgemäßen Herstellung einer Laserdiode mit integriertem Bragg-Gitter.

Zunächst wird eine aluminiumhaltige Schicht 1 vorgesehen, die gemäß einer bevorzugten Ausführungsvariante Teil eines Diodenlasers ist. Jedoch ist die vorliegende Erfindung nicht auf die Anwendung eines Diodenlasers beschränkt. Vielmehr ist es auch möglich, eine mittels des erfindungsgemäßen Verfahrens strukturierte aluminiumhaltige Schicht in anderen Bauteilen zu verwenden, deren Herstellung und Funktion auf ähnlichen Technologien basieren.

Zur Veranschaulichung der vorliegenden Erfindung entspricht die Schicht 1 in Fig. 3 der Wellenleiterschicht 16 in Fig. 1 bzw. der Wellenleiterschicht 12 in Fig. 2.

Zur Integration eines Bragg-Gitters 20 ist es erfindungsgemäß vorgesehen, innerhalb eines Reaktors eine aluminiumhaltige Schicht 1 aufzuwachsen und auf die aluminiumhaltige Schicht 1 eine kontinuierliche aluminiumfreie Schicht 2 aufzubringen, die die aluminiumhaltige Schicht 1 vor einer Oxidation in einem späteren Verfahrensschritt (Schritt S103) außerhalb des Reaktors schützen wird. Weiterhin wird auf die kontinuierliche aluminiumfreie Schicht 2 eine aluminiumfreie Maskenschicht 3 aufgebracht (Schritt S101). Danach wird der Schichtenstapel 1, 2, 3 aus dem (hier nicht dargestellten Reaktor) genommen und es wird eine Lackmaske 4 auf die kontinuierliche Maskenschicht 3 aufgebracht (Schritt S102). Danach wird die Lackmaske 4 mittels herkömmlicher Techniken strukturiert, wobei die Struktur der Lackmaske 4 der späteren Struktur bzw. der späteren inversen Struktur des Braggschen Gitters 20 entspricht (Schritt S103). Beispielsweise wird eine periodische Linienstruktur in die photosensitive Lackschicht 4 belichtet. Anschließend wird der photosensitive Lack 4 entwickelt und als Ätzmaske für das Ätzen der oberen aluminiumfreien Schicht 3 verwendet.

Nachfolgend wird die aluminiumfreie Maskenschicht 3 unter Zuhilfenahme der Lackmaske 4 strukturiert (geätzt), wobei die Struktur der Maskenschicht 3 der Struktur der Lackmaske 4 entspricht oder im Wesentlichen entspricht (Schritt S104). Je nach gewählten Materialien kann die Breite der durch das Ätzen erzeugten Stege der strukturierten Maskenschicht 3 breiter oder schmaler (Unterätzen) als die Stege der Lackmaske 4 sein. Jedoch korrespondieren die Positionen der Stege der strukturierten Maskenschicht 3 mit den Positionen der Stege der Lackmaske 4.

Danach wird die Lackmaske 4 entfernt (Schritt S105). Danach wird der in Schritt S105 dargestellte Schichtenstapel 1, 2, 3 (mit einer strukturierten Maskenschicht 3, die periodische Stege aufweist) in einen Reaktor verbracht.

Das Vorhandensein der unteren aluminiumfreien Schicht 2 ist vorteilhaft, um die Oberflächen-Korrugation in die untere aluminiumhaltige Schicht 1 abformen zu können. Die Notwendigkeit begründet sich aus der Anforderung, die untere aluminiumhaltige Schicht 1 vor dem atmosphärischen Sauerstoff zu schützen und aus der vorzugsweise selektiven Ätzung der oberen aluminiumfreien Schicht 3, die auf der unteren aluminiumfreien Schicht 2 stoppt.

Nachfolgend wird die aluminiumfreie Schicht 2 im Reaktor geätzt (Schritt S106). Gemäß einer ersten bevorzugten Ausführungsvariante (Variante 1) ist es jedoch nicht erforderlich, dass die aluminiumfreie Schicht 2 derart geätzt wird, dass die aluminiumhaltige Schicht 1 freiliegt. Zur Erzeugung eines Bragg-Gitters 20 reicht es bereits aus, wenn die aluminiumfreie Schicht 2 auf eine gewisse Schichtdicke reduziert wird, so dass aufgrund der Stege der Maskenschicht 3 eine abgestufte aluminiumfreie Schicht 2 vorhanden ist, d.h. die aluminiumfreie Schicht 2 weist eine periodische Struktur aus Stegen (größere Dicke im Bereich der Stege der Maskenschicht 3) und Gräben (geringere Dicke im Bereich zwischen den Stegen der Maskenschicht 3) auf - wie der in Schritt S106 dargestellte Schichtenstapel 1, 2, 3. Dann ist es gemäß der ersten bevorzugten Ausführungsvariante (Variante 1) möglich, auf diese periodisch strukturierte aluminiumfreie Schicht 2 eine weitere bevorzugt aluminiumhaltige Schicht 5 aufzubringen.

Die Wirkung des Bragg-Gitters kommt dadurch zustande, dass sich der effektive Brechungsindex eines transversalen Schnittes durch einen Gittersteg vom effektiven Brechungsindex eines transversalen Schnittes zwischen zwei Gitterstegen unterscheidet. Folglich ist der effektive Brechungsindex in der longitudinalen Ausbreitungsrichtung des Lichtes periodisch moduliert.

Wenn die Schicht 5 aluminiumhaltig ist, kann zusätzlich der Aluminiumgehalt während des Aufwachs-Prozesses aufgrund der Struktur der unterliegenden Schichten 2, 3 in den Bereichen zwischen und über den Stegen der Maskenschicht 3 variieren, so dass die aluminiumhaltigen Schicht 5 eine periodische Struktur von hohem Aluminiumgehalt (im Bereich der Stege der Maskenschicht 3 - siehe auch 20b in Fig. 1 und 2) und niedrigem Aluminiumgehalt (im Bereich zwischen den Stegen der Maskenschicht 3 - siehe auch 20c in Fig. 1 und 2) aufweist (im Schritt S115 nicht eingezeichnet). Die periodische Variation des Aluminiumgehalts geht mit einer zusätzlichen periodischen Variation der Brechzahl einher, welche die Wirkung des Bragg-Gitters verstärken (bevorzugt) oder abschwächen kann. Das aus mindestens einem der genannten Effekte resultierende Bragg-Gitter bewirkt eine spektrale Stabilisierung der Emissionswellenlänge der Laserdiode.

In der Variante 1 kann auch ein Teil der Maskenschicht 3 im Bragg-Gitter 20 verbleiben.

Es ist möglich, die Oberflächen-Korrugation der Schicht 3 nur bis in die untere aluminiumfreie Schicht 2 abzuformen, so dass eine dünne, kontinuierliche aluminiumfreie Schicht 2 die untere aluminiumhaltige Schicht 1 bedeckt. Tatsächlich erzielen auf diese Weise hergestellte DFB-BA Laser sehr hohe Leistungen (≈ 11 W) und Konversionseffizienzen (≈ 58 %). Lediglich der Serienwiderstand ist, bedingt durch die kontinuierliche aluminiumfreie Schicht 2 etwas höher als bei Lasern, wo diese Schicht 2 zwischen den Gitterstegen entfernt ist (Varianten 2 und 3).

Gemäß einer zweiten bevorzugten Ausführungsvariante (Variante 2) wird die aluminiumfreie Schicht 2 im Reaktor, nahezu unter Ausschluss von Sauerstoff, so dass die Oxidation der Oberfläche verhindert wird, derart geätzt, dass die aluminiumhaltige Schicht 1 freiliegt (Schritt S107). Der Ätzangriff kann gemäß Variante 2 wahlweise beendet sein, wenn die aluminiumhaltige Schicht 1 zwischen den Gitterstegen, bestehend aus den aluminiumfreien Schichten 2 und 3 freigelegt ist (Schritt 107), oder der Ätzangriff kann über die Grenzfläche zwischen den Schichten 2 und 1 hinaus fortgesetzt werden (Schritt 108). Dann kann wieder eine weitere bevorzugt aluminiumhaltige Schicht 5 aufgewachsen werden (Schritt 109).

Wie in Variante 1 kommt die Wirkung des Bragg-Gitters dadurch zustande, dass sich der effektive Brechungsindex eines transversalen Schnittes durch einen Gittersteg vom effektiven Brechungsindex eines transversalen Schnittes zwischen zwei Gitterstegen unterscheidet (nachfolgend auch als Effekt 1 bezeichnet). Wenn die Schicht 5 aluminiumhaltig ist, kann zusätzlich der Aluminiumgehalt während des Aufwachs-Prozesses aufgrund der Struktur der unterliegenden Schichten 2, 3 in den Bereichen zwischen und über den Stegen der Maskenschicht 3 variieren, so dass die aluminiumhaltigen Schicht 5 eine periodische Struktur von hohem Aluminiumgehalt (im Bereich der Stege der Maskenschicht 3 - siehe auch 20b in Fig. 1 und 2) und niedrigem Aluminiumgehalt (im Bereich zwischen den Stegen der Maskenschicht 3 - siehe auch 20c in Fig. 1 und 2) aufweist (im Schritt S109 nicht eingezeichnet) nachfolgend auch als Effekt 2 bezeichnet). Die periodische Variation des Aluminiumgehalts geht mit einer zusätzlichen periodischen Variation der Brechzahl einher, welche die Wirkung des Bragg-Gitters verstärken (bevorzugt) oder abschwächen kann. Das aus mindestens einem der genannten Effekte resultierende Bragg-Gitter bewirkt eine spektrale Stabilisierung der Emissionswellenlänge der Laserdiode.

In einer weiteren bevorzugten Ausführungsvariante (Variante 3) wird die aluminiumhaltige Schicht 1 im Reaktor, nahezu unter Ausschluss von Sauerstoff, so dass die Oxidation der Oberfläche verhindert wird, noch weiter geätzt, so dass die Maskenschicht 3 vollständig weggeätzt wird (Schritt 110), die Stege/Gräben der aluminiumhaltige Schicht 1 noch tiefer werden (Schritt 111) oder sogar die aluminiumfreie Schicht 2 vollständig weggeätzt wird (Schritt 112). Nach jedem der Schritte S110, S111 und S112 kann wieder eine weitere, bevorzugt aluminiumhaltige Schicht 5 aufgewachsen werden.

Die Wirkung des Bragg-Gitters kommt dadurch zustande, dass sich der effektive Brechungsindex eines transversalen Schnittes durch einen Gittersteg vom effektiven Brechungsindex eines transversalen Schnittes zwischen zwei Gitterstegen unterscheidet (Effekt 1). Wenn die Schicht 5 aluminiumhaltig ist, kann zusätzlich der Aluminiumgehalt während des Aufwachs-Prozesses aufgrund der Struktur der unterliegenden Schichten 2, 3 in den Bereichen zwischen und über den Stegen der Maskenschicht 3 variieren, so dass die aluminiumhaltigen Schicht 5 eine periodische Struktur von hohem Aluminiumgehalt (im Bereich der Stege der Maskenschicht 3 - siehe auch 20b in Fig. 1 und 2) und niedrigem Aluminiumgehalt (im Bereich zwischen den Stegen der Maskenschicht 3 - siehe auch 20c in Fig. 1 und 2) aufweist (im Schritt S114 eingezeichnet) (Effekt 2). Die periodische Variation des Aluminiumgehalts geht mit einer zusätzlichen periodischen Variation der Brechzahl einher, welche die Wirkung des Bragg-Gitters verstärken (bevorzugt) oder abschwächen kann. Das aus beiden Effekten resultierende Bragg-Gitter bewirkt eine spektrale Stabilisierung der Emissionswellenlänge der Laserdiode.

Der Aluminiumgehalt der Schicht 5 kann einerseits so gewählt der werden, dass er dem Aluminiumgehalt der Schicht 1 entspricht oder im Wesentlichen entspricht (Abweichung bevorzugt kleiner 5 %). Die Wirkung des Bragg-Gitters kommt in diesem Fall dadurch zu Stande, dass sich Bereiche 5a mit unverändertem Aluminiumgehalt, Bereiche 5b mit erhöhtem Aluminiumgehalt und Bereiche 5c mit reduziertem Aluminiumgehalt (Schritt 114) ausbilden.

Andererseits ist es möglich, dass die Schicht 5 einen von der Schicht 1 unterschiedlichen Aluminiumgehalt besitzt (Schritt 113), wodurch eine Wirkung des Bragg-Gitters auch dann zustande kommt, wenn nur Effekt 1 und nicht Effekt 2 beiträgt.

Es gibt erfindungsgemäß (wie oben erläutert) nicht notwendigerweise lediglich eine separate Gitterschicht 20, sondern es kann eine Vielzahl von Schichten zur Gitterwirkung beitragen. Welche Schichten das sind, hängt jeweils von der Herstellung ab (siehe Varianten 1, 2 und 3 in der Figur).

Als Bragg-Gitter 20 wird eine periodische Modulation des komplexen Brechungsindex in der longitudinalen Ausbreitungsrichtung des Lichtes verstanden.

Die Wirkung des Bragg-Gitters 20 als optisches Gitter ergibt sich aus dem Kontrast des effektiven Brechungsindex zwischen transversalen Schnittebenen, der zu einer Bragg-Streuung führt und zu konstruktiver Interferenz der gestreuten Anteile des Lichts, welche die Bragg-Bedingung der ersten oder einer höheren Ordnung (bei Bragg-Gittern höherer Ordnung) erfüllen.

Bei den mit dem in Fig. 3 dargestellten, erfindungsgemäßen Verfahren hergestellten Laserdioden, kann eine Oxidierung der Grenzfläche zwischen dem Bragg-Gitter 20 und der mindestens einen aluminiumhaltigen Schicht (12, 14, 16 oder 18) vorteilhafterweise vermieden werden. Die Konzentration von Sauerstoff im Bereich der Grenzfläche ist deshalb besonders bevorzugt kleiner als 0,01 % bzw. < 10¹⁷ cm⁻³.

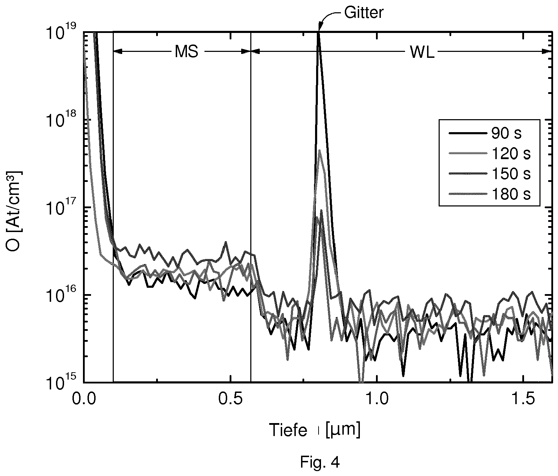

Bevorzugt ist die Dichte der Sauerstoff-Atome im Halbleitermaterial geringer als 10¹⁹ cm⁻³, besonders bevorzugt geringer als 10¹⁸ cm⁻³ und noch bevorzugter geringer als 10¹⁷ cm⁻³. Der Einfluss von Ätzzeit (Schritte 104 bis 112) auf den Sauerstoffgehalt ist in Fig. 4 dargestellt, wobei MS die Mantelschicht 14 bzw. 18 und WL die Wellenleiterschicht 12 zw. 16 repräsentieren. Das dargestellte Gitter besteht vor der Ätzung aus einer 25 nm dicken strukturierten (selektiv durchgeätzten) Maskenschicht aus Galliumarsenid und aus einer 20 nm dicken aluminiumfreien Schicht aus Galliumindiumphosphid. Es hat sich herausgestellt, dass der Konversionswirkungsgrad einer mit dem erfindungsgemäßen Verfahren hergestellten Laserdiode mit einem Sauerstoffgehalt größer als 10¹⁸ cm⁻³ an der Grenzfläche zwischen dem ersten und dem zweiten Wachstumsprozess (entspricht einer Gesamtätzzeit < 100 s) kleiner als 50 % beträgt. Weiterhin beträgt der Konversionswirkungsgrad einer mit dem erfindungsgemäßen Verfahren hergestellten Laserdiode mit einem Sauerstoffgehalt kleiner als 10¹⁸ cm⁻³ (entspricht einer Gesamtätzzeit von 120 s) zirka 58 % und der Konversionswirkungsgrad einer mit dem erfindungsgemäßen Verfahren hergestellten Laserdiode mit einem Sauerstoffgehalt kleiner als 10¹⁷ cm⁻³ (entspricht einer Gesamtätzzeit von mehr als 140 s) beträgt mehr als 60 %. Es ist daher erfindungsgemäß besonders bevorzugt, eine Gesamtätzzeit von mehr als 140 s für diesen Reaktortyp zu wählen.

### Bezugszeichenliste

- 1: Erste, aluminiumhaltige Schicht
- 2: Aluminiumfreie Schicht
- 3: Aluminiumfreie Maskenschicht
- 4: Lackmaske
- 5: Zweite aluminiumhaltige Schicht
- 5a: Region mit unverändertem Aluminiumgehalt
- 5b: Region mit erhöhtem Aluminiumgehalt
- 5c: Region mit reduziertem Aluminiumgehalt
- 10: Aktive Schicht
- 12: Erste Wellenleiterschicht (n-leitend)
- 14: Erste Mantelschicht (n-leitend)
- 16: Zweite Wellenleiterschicht (p-leitend)
- 18: Zweite Mantelschicht (p-leitend)
- 20: Bragg-Gitter Region
- 20a: Gittersteg
- 20b: Region mit erhöhtem Aluminiumgehalt
- 20c: Region mit reduziertem Aluminiumgehalt
- 28: Substrat (n-leitend)
- 30: P-Kontakt
- 32: N-Kontakt

## Patentansprüche

1. Verfahren zur Herstellung eines Diodenlasers mit folgenden Verfahrensschritten:
Ausbilden einer ersten Mantelschicht (14), einer ersten Wellenleiterschicht (12), einer aktiven Schicht (10), einer zweiten Wellenleiterschicht (16), und einer zweiten Mantelschicht (18), wobei mindestens eine Schicht ausgewählt aus der Gruppe erste Mantelschicht (14), erste Wellenleiterschicht (12), zweite Wellenleiterschicht (16) und zweite Mantelschicht (18) eine erste aluminiumhaltige Schicht (1) aufweist; und Ausbilden eines Bragg-Gitters (20) auf oder innerhalb der ersten aluminiumhaltigen Schicht (1), wobei die Ausbildung des Bragg-Gitters (20) folgende Schritte umfasst:
(a) auf die erste aluminiumhaltige Schicht (1) wird innerhalb eines Reaktors eine kontinuierliche aluminiumfreie Schicht (2) aufgebracht, und nachfolgend auf die aluminiumfreie Schicht (2) eine kontinuierliche aluminiumfreie Maskenschicht (3) derart aufgebracht, dass die erste aluminiumhaltige Schicht (1) vollständig von der kontinuierlichen aluminiumfreien Schicht (2) überdeckt wird (S101),
(b) nachfolgend wird außerhalb des Reaktors eine Lackmaske (4) auf die kontinuierliche Maskenschicht (3) aufgebracht (S102) und strukturiert (S103), und nachfolgend wird die kontinuierliche Maskenschicht (3) durch Ätzung derart strukturiert, dass die Maskenschicht (3) der Struktur der Lackmaske (4) entspricht oder im Wesentlichen entspricht, die aluminiumfreie Schicht (2) zumindest teilweise freiliegt und die aluminiumhaltige Schicht (1) von der aluminiumfreien Schicht (2) vollständig überdeckt wird (S104, S105),
(c) nachfolgend wird die aluminiumfreie Schicht (2) innerhalb eines Reaktors durch Abformung der strukturierten Maskenschicht (3) mittels eines gasförmigen Ätzmediums derart strukturiert, dass die aluminiumfreie Schicht (2) eine Gitterstruktur aufweist (S106), und
(d) nachfolgend wird innerhalb eines Reaktors eine zweite Schicht (5) aufgebracht (S109, S113, S114, S115),
**dadurch gekennzeichnet, dass**
die aluminiumfreie Schicht (2) vor Durchführung des Verfahrensschrittes d) derart strukturiert wird, dass die aluminiumhaltige Schicht (1) von der aluminiumfreien Schicht (2) nicht freigelegt wird (S115), oder dass die aluminiumfreie Schicht (2) vor Durchführung des Verfahrensschrittes d) vollständig weggeätzt wird (S112).

2. Verfahren nach Anspruch 1,
**dadurch gekennzeichnet, dass**
die zweite Schicht (5) eine aluminiumhaltige Schicht ist.

3. Verfahren nach mindestens einem der vorhergehenden Ansprüche,
**dadurch gekennzeichnet, dass**
Verfahrensschritt b) außerhalb des in Verfahrensschritt a) verwendeten Reaktors durchgeführt wird.

4. Verfahren nach mindestens einem der vorhergehenden Ansprüche,
**dadurch gekennzeichnet, dass**
der Sauerstoffpartialdruck innerhalb des Reaktors während der Verfahrensschritte a), c) und d) kleiner als 5^{∗}10⁻⁶ Pa ist.

5. Verfahren nach Anspruch 4,
**dadurch gekennzeichnet, dass**
der Sauerstoffpartialdruck während der Durchführung des Verfahrensschrittes b) größer als 5^{∗}10⁻⁶ Pa ist.

6. Verfahren nach einem der vorhergehenden Ansprüche,
**dadurch gekennzeichnet, dass**
die Maskenschicht (3) vor Durchführung des Verfahrenschrittes d) vollständig weggeätzt wird (S110, S111).

7. Verfahren nach einem der vorhergehenden Ansprüche,
**dadurch gekennzeichnet, dass**
die Schicht (5) aluminiumhaltig ist und dass der Aluminiumgehalt der Schicht (5) im Verfahrensschritt d) in einem Bereich oberhalb der in Verfahrensschritt c) strukturierten Oberfläche eine räumlich inhomogene Verteilung der Aluminiumkonzentration aufweist.

8. Verfahren nach Anspruch 7,
**dadurch gekennzeichnet, dass**
die Schicht (5) im Verfahrensschritt d) Bereiche mit einem höheren Aluminiumgehalt (5b), Bereiche mit einem geringeren Aluminiumgehalt (5c) und oberhalb davon einen durchgehenden Bereich mit einem nominellen Aluminiumgehalt (5a) (S114) aufweist.

9. Verfahren nach einem der vorhergehenden Ansprüche,
**dadurch gekennzeichnet, dass**
als aluminiumfreie Maskenschicht (3) Galliumarsenid oder Galliumarsenidphosphid verwendet wird und/oder als aluminiumfreie Schicht (2) ein Verbindungshalbleiter-Material, welches ein Element ausgewählt aus der Gruppe Indium, Gallium, Phosphor, Arsen, Antimon und Stickstoff umfasst, verwendet wird.

10. Verfahren nach Anspruch 8,
**dadurch gekennzeichnet, dass**
als aluminiumfreie Schicht (2) Galliumarsenid, Galliumindiumphosphid oder Galliumarsenidphosphid verwendet wird.

11. Diodenlaser, hergestellt nach einem Verfahren gemäß einem der Ansprüche 1 bis 10, aufweisend:
eine erste Mantelschicht (14), eine erste Wellenleiterschicht (12), die auf der ersten Mantelschicht (14) angeordnet ist, eine aktive Schicht (10), die zur Strahlungserzeugung geeignet ist und die auf der ersten Wellenleiterschicht (12) angeordnet ist, eine zweite Wellenleiterschicht (16), die auf der aktiven Schicht (10) angeordnet ist, und eine zweite Mantelschicht (18), die auf der zweiten Wellenleiterschicht (16) angeordnet ist, wobei mindestens eine Schicht ausgewählt aus der Gruppe erste Mantelschicht (14), erste Wellenleiterschicht (12), zweite Wellenleiterschicht (16) und zweite Mantelschicht (18) aluminiumhaltig ist oder eine aluminiumhaltige Teilschicht (1) aufweist; und ein Bragg-Gitter (20), wobei das Bragg-Gitter (20) auf oder innerhalb der mindestens einen aluminiumhaltigen Schicht (1) ausgebildet ist,
**dadurch gekennzeichnet, dass**
die Grenzfläche zwischen dem Bragg-Gitter (20) und der mindestens einen aluminiumhaltigen Schicht (1) eine Konzentration von Sauerstoff von kleiner als 1^{∗}10¹⁷ cm⁻³ aufweist.

## Claims

1. A method for producing a diode laser, having the following method steps:
forming a first cladding layer (14), a first waveguide layer (12), an active layer (10), a second waveguide layer (16), and a second cladding layer (18), wherein at least one layer selected from the group of first cladding layer (14), first waveguide layer (12), second waveguide layer (16) and second cladding layer (18) has a first aluminium-containing layer (1); and forming a Bragg grating (20) on or within the first aluminium-containing layer (1), wherein the formation of the Bragg grating (20) comprises the following steps:
(a) a continuous aluminium-free layer (2) is deposited onto the first aluminium-containing layer (1) within a reactor, and a continuous aluminium-free mask layer (3) is subsequently deposited onto the aluminium-free layer (2) such that the first aluminium-containing layer (1) is completely covered by the continuous aluminium-free layer (2) (S101),
(b) a resist mask (4) is subsequently deposited onto the continuous mask layer (3) (S102) and structured (S103) outside the reactor, and the continuous mask layer (3) is subsequently structured by etching such that the mask layer (3) corresponds or substantially corresponds to the structure of the resist mask (4), the aluminium-free layer (2) is at least partially exposed and the aluminium-containing layer (1) is completely covered by the aluminium-free layer (2) (S104, S105),
(c) the aluminium-free layer (2) is subsequently structured within a reactor by impressing the structured mask layer (3) by means of a gaseous etching medium such that the aluminium-free layer (2) has a grid structure (S106), and
(d) a second layer (5) is subsequently deposited within a reactor (S109, S113, S114, S115),
**characterised in that**
the aluminium-free layer (2) is structured such that the aluminium-containing layer (1) is not exposed by the aluminium-free layer (2) (S115) before performing method step d) or the aluminium-free layer (2) is completely etched away (S112) before performing method step d).

2. The method according to Claim 1,
**characterised in that**
the second layer (5) is an aluminium-containing layer.

3. The method according to at least one of the preceding claims,
**characterised in that**
method step b) is performed outside the reactor used in method step a).

4. The method according to at least one of the preceding claims,
**characterised in that**
the partial pressure of oxygen inside the reactor while performing method steps a), c) and d) is less than 5^{∗}10⁻⁶ Pa.

5. The method according to Claim 4,
**characterised in that**
the partial pressure of oxygen while performing the method step b) is greater than 5^{∗}10⁻⁶ Pa.

6. The method according to any one of the preceding claims,
**characterised in that**
the mask layer (3) is completely etched away (S110, S111) before performing method step d).

7. The method according to any one of the preceding claims,
**characterised in that**
the layer (5) is aluminium-containing and the aluminium content of the layer (5) in method step d) has a spatially inhomogeneous distribution of the aluminium concentration in a region above the surface structured in method step c).

8. The method according to Claim 7,
**characterised in that**
in method step d), the layer (5) has regions with a higher aluminium content (5b), regions with a lower aluminium content (5c) and above these a continuous region with a nominal aluminium content (5a) (S114).

9. The method according to any one of the preceding claims,
**characterised in that**
gallium arsenide or gallium arsenide phosphide is used as the aluminium-free mask layer (3), and/or a semiconductor material which comprises one element selected from the group consisting of indium, gallium, phosphorus, arsenic, antimony and nitrogen is used as the aluminium-free layer (2).

10. The method according to Claim 8,
**characterised in that**
gallium arsenide, gallium indium phosphide or gallium arsenide phosphide is used as the aluminium-free layer (2).

11. A diode laser, produced according to a method according to any one of Claims 1 to 10, having:
a first cladding layer (14), a first waveguide layer (12) which is arranged on the first cladding layer (14), an active layer (10) which is suitable for generating radiation and which is arranged on the first waveguide layer (12), a second waveguide layer (16) which is arranged on the active layer (10), and a second cladding layer (18) which is arranged on the second waveguide layer (16), wherein at least one layer selected from the group of first cladding layer (14), first waveguide layer (12), second waveguide layer (16) and second cladding layer (18) contains aluminium or has an aluminium-containing partial layer (1); and a Bragg grating (20), wherein the Bragg grating (20) is formed on or within the at least one aluminium-containing layer (1),
**characterised in that**
the boundary layer between the Bragg grating (20) and the at least one aluminium-containing layer (1) has a concentration of oxygen less than 1^{∗}10¹⁷ cm⁻³.

## Revendications

1. Procédé de fabrication d'une diode laser, comprenant les étapes de procédé suivantes :
la formation d'une première couche d'enveloppe (14), d'une première couche de guide d'ondes (12), d'une couche active (10), d'une deuxième couche de guide d'ondes (16), et d'une deuxième couche d'enveloppe (18), au moins une couche choisie dans le groupe constitué par la première couche d'enveloppe (14), la première couche de guide d'ondes (12), la deuxième couche de guide d'ondes (16) et la deuxième couche d'enveloppe (18) comprenant une première couche contenant de l'aluminium (1) ; et
la formation d'un réseau de Bragg (20) sur ou dans la première couche contenant de l'aluminium (1), la formation du réseau de Bragg (20) comprenant les étapes suivantes :
(a) une couche continue exempte d'aluminium (2) est appliquée sur la première couche contenant de l'aluminium (1) dans un réacteur, puis une couche de masque continue exempte d'aluminium (3) est appliquée sur la couche exempte d'aluminium (2) de telle sorte que la première couche contenant de l'aluminium (1) soit entièrement recouverte par la couche continue exempte d'aluminium (2) (S101),
(b) un masque de vernis (4) est appliqué (S102) à l'extérieur du réacteur sur la couche de masque continue (3), et structuré (S103), puis la couche de masque continue (3) est structurée par décapage, de telle sorte que la couche de masque (3) corresponde ou corresponde essentiellement à la structure du masque de vernis (4), que la couche exempte d'aluminium (2) soit au moins partiellement dégagée et que la couche contenant de l'aluminium (1) soit entièrement recouverte par la couche exempte d'aluminium (2) (S104, S105),
(c) la couche exempte d'aluminium (2) est structurée dans un réacteur par moulage de la couche de masque structurée (3) au moyen d'un milieu décapant gazeux, de telle sorte que la couche exempte d'aluminium (2) présente une structure de réseau (S106),
(d) une deuxième couche (5) est appliquée dans un réacteur (S109, S113, S114, S115),
**caractérisé en ce que**
la couche exempte d'aluminium (2) est structurée avant la réalisation de l'étape de procédé d) de telle sorte que la couche contenant de l'aluminium (1) ne soit pas dégagée de la couche exempte d'aluminium (2) (S115), ou de telle sorte que la couche exempte d'aluminium (2) soit entièrement décapée (S112) avant la réalisation de l'étape de procédé d).

2. Procédé selon la revendication 1,
**caractérisé en ce que**
la deuxième couche (5) est une couche contenant de l'aluminium.

3. Procédé selon au moins l'une quelconque des revendications précédentes,
**caractérisé en ce que**
l'étape de procédé b) est réalisée à l'extérieur du réacteur utilisé à l'étape de procédé a).

4. Procédé selon au moins l'une quelconque des revendications précédentes,
**caractérisé en ce que**
la pression partielle d'oxygène dans le réacteur pendant les étapes de procédé a), c) et d) est inférieure à 5^{∗}10⁻⁶ Pa.

5. Procédé selon la revendication 4,
**caractérisé en ce que**
la pression partielle d'oxygène pendant la réalisation de l'étape de procédé b) est supérieure à 5^{∗}10⁻⁶ Pa.

6. Procédé selon l'une quelconque des revendications précédentes,
**caractérisé en ce que**
la couche de masque (3) est entièrement décapée (S110, S111) avant la réalisation de l'étape de procédé d).

7. Procédé selon l'une quelconque des revendications précédentes,
**caractérisé en ce que**
la couche (5) contient de l'aluminium, et **en ce que** la teneur en aluminium de la couche (5) à l'étape de procédé d) présente dans une zone au-dessus de la surface structurée à l'étape de procédé c) une distribution inhomogène dans l'espace de la concentration en aluminium.

8. Procédé selon la revendication 7,
**caractérisé en ce que**
la couche (5) à l'étape de procédé d) présente des zones ayant une teneur en aluminium plus élevée (5b), des zones ayant une teneur en aluminium plus faible (5c) et, au-dessus de celles-ci, une zone continue ayant une teneur en aluminium nominale (5a) (S114).

9. Procédé selon l'une quelconque des revendications précédentes,
**caractérisé en ce que**
de l'arséniure de gallium ou de l'arséniure-phosphure de gallium est utilisé en tant que la couche de masque exempte d'aluminium (3), et/ou un matériau semiconducteur composé, qui comprend un élément choisi dans le groupe constitué par l'indium, le gallium, le phosphore, l'arsenic, l'antimoine et l'azote, est utilisé en tant que la couche exempte d'aluminium (2).

10. Procédé selon la revendication 8,
**caractérisé en ce que**
de l'arséniure de gallium, du phosphure de gallium et d'indium ou de l'arséniure-phosphure de gallium est utilisé en tant que la couche exempte d'aluminium (2).

11. Diode laser, fabriquée par un procédé selon l'une quelconque des revendications 1 à 10, comprenant :
une première couche d'enveloppe (14), une première couche de guide d'ondes (12), qui est agencée sur la première couche d'enveloppe (14), une couche active (10), qui est appropriée pour la génération d'un rayonnement et qui est agencée sur la première couche de guide d'ondes (12), une deuxième couche de guide d'ondes (16), qui est agencée sur la couche active (10), et une deuxième couche d'enveloppe (18), qui est agencée sur la deuxième couche de guide d'ondes (16), au moins une couche choisie dans le groupe constitué par la première couche d'enveloppe (14), la première couche de guide d'ondes (12), la deuxième couche de guide d'ondes (16) et la deuxième couche d'enveloppe (18) contenant de l'aluminium ou comprenant une couche partielle contenant de l'aluminium (1) ; et un réseau de Bragg (20), le réseau de Bragg (20) étant formé sur ou dans ladite au moins une couche contenant de l'aluminium (1),
**caractérisée en ce que**
l'interface entre le réseau de Bragg (20) et ladite au moins une couche contenant de l'aluminium (1) présente une concentration en oxygène de moins de 1^{∗}10¹⁷ cm⁻³.
